(19) Europäisches Patentamt
European Patent Office
Office européen des brevets

(11) **EP 3 527 692 A1**

(12) **EUROPÄISCHE PATENTANMELDUNG**

(43) Veröffentlichungstag:
21.08.2019  Patentblatt 2019/34

(51) Int Cl.:
*C23C 16/455* (2006.01)    *C23C 16/503* (2006.01)
*C23C 16/515* (2006.01)    *C23C 16/452* (2006.01)
*C23C 16/40* (2006.01)    *C23C 16/513* (2006.01)
*H01J 37/32* (2006.01)

(21) Anmeldenummer: 19157492.0

(22) Anmeldetag: **15.02.2019**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**KH MA MD TN**

(30) Priorität: **19.02.2018   DE 102018202438**

(71) Anmelder: **FRAUNHOFER-GESELLSCHAFT zur Förderung**
**der angewandten Forschung e.V.**
**80686 München (DE)**

(72) Erfinder:
• **Emmerich, Rudolf**
  **76456 Kuppenheim (DE)**
• **Dreher, Ralf**
  **75045 Walzbachtal (DE)**

(74) Vertreter: **Haggenmüller, Christian**
**Maiwald Patentanwalts- und Rechtsanwaltsgesellschaft mbH**
**Elisenhof**
**Elisenstraße 3**
**80335 München (DE)**

(54)  **VERFAHREN ZUR HERSTELLUNG EINER HAFTVERMITTELNDEN BESCHICHTUNG**

(57)    Die vorliegende Erfindung betrifft ein Verfahren zum Beschichten eines Trägermaterials, wobei die Beschichtung über eine plasmaunterstützte chemische Gasphasenabscheidung bei Atmosphärendruck (AP-PECVD) im Remote-Betrieb erfolgt und wobei

- die Gasmengenströme des Plasmagases, des Trägergases und des Precursors der folgenden Bedingung genügen:

$$Q(\text{Precursor}) / [Q(G_{\text{Plasma}}) + Q(G_{\text{Remote}})] \geq 1 / 2200$$

- und die mittlere eingespeiste Leistung und der Gasmengenstrom des Precursors der folgenden Bedingung genügen:

$$0{,}01 \leq Q(\text{Precursor}) / P_m \leq 1{,}0.$$

EP 3 527 692 A1

**Beschreibung**

Für eine Reihe von Anwendungen sind Composite-Materialien erforderlich, bei denen eine erste Materialkomponente, z.B. eine Polymerkomponente, mit einer zweiten Materialkomponente, z.B. einer weiteren Polymerkomponente oder einem anderen Material wie Keramik, Glas oder Metall, verbunden ist (d.h. eine gemeinsame Grenzfläche aufweisen). Eine gute Haftfestigkeit zwischen diesen Materialien ist dabei üblicherweise erwünscht.

Zur Verbesserung der Haftung sind verschiedene Ansätze bekannt.

Durch eine Plasmabehandlung können auf der Oberfläche eines ersten Materials polare Gruppen erzeugt oder Moleküle mit spezifischer Funktionalität verankert werden, wodurch die Haftfestigkeit zwischen diesem ersten Material und einem darauf aufgebrachten zweiten Material verbessert wird. Dieser Ansatz beschreibt z.B. U. Stöhr, "Surface Activation of Plastics by Plasma for Adhesion Promotion", WOMag, Band 5, 2016, S. 15-17.

DE 10 2012 220 286 A1 beschreibt ein Verfahren zur Erhöhung der Adhäsion zwischen einer Haftklebeschicht und der Oberfläche eines Substrats, wobei die dem Substrat zugewandte Oberfläche der Haftklebeschicht mit einem Atmosphärendruckplasma behandelt wird, das Atmosphärendruckplasma mit einer Mischung aus Prozessgasen gebildet wird und die Mischung zumindest 90 Vol-% Stickstoff und zumindest ein Edelgas enthält.

Gemäß eines weiteren Ansatzes zur Verbesserung der Haftfestigkeit werden durch Materialabtrag Löcher oder Poren in der Oberfläche eines ersten Materials erzeugt. Wird anschließend eine Polymerschmelze aufgebracht, kann diese in die Poren eindringen. Nach der Verfestigung der Schmelze kommt es zu einer effektiven mechanischen Verhakung bzw. Verzahnung des Polymers mit dem Substrat. So beschreibt beispielsweise EP 2 572 876 A1 ein Verfahren zur Herstellung eines Metall-Harz-Verbundbauteils, bei dem durch Anodisierung Löcher in der Aluminiumoberfläche generiert wurden und anschließend das Aufbringen eines thermoplastischen Polymers durch Spritzguss erfolgte.

Alternativ zum Materialabtrag können die haftvermittelnden Poren oder Löcher auch durch das Aufbringen einer porösen Schicht generiert werden.

So beschreibt beispielsweise DE 10 2011 086 399 A1 das Aufbringen einer haftvermittelnden porösen Schicht über eine Plasma-unterstützte chemische Gasphasenabscheidung (PE-CVD). Die Abscheidung erfolgte dabei unter Vakuum- bzw. Niederdruckbedingungen. Dies erfordert jedoch einen erhöhten apparativen Aufwand und erschwert die einfache Integration in die Fertigungskette. Außerdem handelt es sich bei einer Niederdruck-PECVD-Vorrichtung üblicherweise um eine Flächenquelle. Sollen nur selektive Bereiche eines Substrats beschichtet werden, muss daher eine Maske aufgebracht werden.

Ein PECVD-Reaktor kann nach der sogenannten Direkt-Plasma-Methode oder alternativ nach der sogenannten "Remote-Plasma-Methode" ("Remote-PECVD") betrieben werden.

Bei der Direkt-Plasma-Methode wird die die Schicht bildende Precursor-Verbindung zusammen mit dem Arbeitsgas in die das Plasma erzeugende Kammer eingeleitet. Das Plasma wird üblicherweise zwischen dem zu beschichtenden Substrat und einer Gegenelektrode durch ein starkes elektrisches Feld gezündet. Das Substrat kommt also in direkten Kontakt mit dem Plasma, was die Gefahr einer Schädigung der Substratoberfläche erhöht.

Arbeitet ein PECVD-Reaktor im Remote-Betrieb (Remote-PECVD), wird der die Beschichtung bildende Precursor nicht bereits mit dem Arbeitsgas durch die das Plasma erzeugende Einheit geleitet, sondern wird dem bereits erzeugten Plasma erst am Ausgang der Plasmadüse zugeführt.

Weiterhin ist für Plasma-unterstützte chemische Gasphasenabscheidungen (PECVD) bekannt, dass diese unter Vakuum- bzw. Niederdruckbedingungen oder auch unter Atmosphärendruck ("AP-PECVD") erfolgen können. Bei einem AP-PECVD-Verfahren bezieht sich die Angabe "Atmosphärendruck" auf den Druck, dem das zu beschichtende Substrat kurz vor der Beschichtung ausgesetzt ist (also der Startdruck).

J. Haag et al., Journal of Materials Science and Engineering A 5 (7-8), 2015, 274-284, doi: 10.17265/2161-6213/2015.7-8.004, beschreiben die Abscheidung einer haftvermittelnden Beschichtung auf einer Titanlegierung über eine Plasma-unterstützte chemische Gasphasenabscheidung bei Atmosphärendruck (AP-PECVD). Der AP-PECVD-Reaktor arbeitet im Remote-Betrieb. In dem von J. Haag et al. beschriebenen Verfahren wird ein "Plasma-Gas" (d.h. das in ein Plasma zu überführende Gas) der Plasma-erzeugenden Einheit zugeführt, während die Precursor-Verbindung zusammen mit einem Trägergas (das auch als "Remote-Gas" bezeichnet wird) dem Plasma am Ausgang der Plasma-erzeugenden Einheit zugeführt wird. Der Gasmengenstrom des Plasma-Gases beträgt 120 SLM und der des Remote-Gases beträgt 60 SLM. Für die Precursor-Verbindung beträgt der Gasmengenstrom 30 g/Stunde, dies entspricht 0,069 SLM. Somit arbeitet das von J. Haag et al. beschriebene Verfahren mit einer sehr geringen Precursor-Konzentration.

Sofern das Substrat eine ebene Oberfläche aufweist, wird mit dem von J. Haag et al. beschriebenen Verfahren eine dichte (d.h. unporöse) Schicht abgeschieden. Um eine poröse Schicht zu erhalten, wird zunächst das zu beschichtende Substrat geätzt. Durch diesen Ätzschritt werden in der Oberfläche des Substrats Gräben oder Poren im Mikrometer-Maßstab erzeugt. Bei der anschließenden Beschichtung über PECVD im Remote-Betrieb bei Atmosphärendruck ("*Remote-AP-PECVD*") übertragen sich diese Unebenheiten der geätzten Substratoberfläche auf die abgeschiedene Schicht. Es wird eine poröse Beschichtung mit relativ großen Poren oder Gräben erhalten.

Nachteilig bei diesem Verfahren von J. Haag et al. ist der für das Generieren einer Porosität erforderliche zusätzliche Ätzschritt, da dieser das Substrat schädigt und das Verfahren aufwendiger macht. Außerdem lässt sich dieses Verfahren nur auf Substrate anwenden, die sich entsprechend ätzen lassen.

Eine Aufgabe der vorliegenden Erfindung ist das Aufbringen einer als Haftvermittler fungierenden Beschichtung über ein Verfahren, das möglichst einfach und effizient durchgeführt werden kann, für eine Vielzahl unterschiedliche Substrate anwendbar ist und für das zu beschichtende Substrat möglichst schonend ist und sich gut in eine Fertigungskette integrieren lässt.

Gelöst wird die Aufgabe durch ein Verfahren zum Beschichten eines Trägermaterials, wobei die Beschichtung über eine plasmaunterstützte chemische Gasphasenabscheidung bei Atmosphärendruck (AP-PECVD) erfolgt, wobei

- die Zündung des Plasmas in einer Plasma-erzeugenden Einheit, in die ein Precursor-freies Gas $G_{Plasma}$ eingeleitet wird, erfolgt,
- der Precursor mit einem Trägergas $G_{Remote}$ dem bereits erzeugten Plasma zugeführt wird,
- 

$$Q(Precursor) / [Q(G_{Plasma}) + Q(G_{Remote})] \geq 1 / 2200$$

wobei

Q(Precursor) der Gasmengenstrom, in Standard-Liter pro Minute (SLM), des dem Plasma zugeführten Precursors ist,
$Q(G_{Plasma})$ der Gasmengenstrom, in Standard-Liter pro Minute (SLM), des in die Plasma-erzeugende Einheit eingeleiteten Precursor-freien Gases $G_{Plasma}$, ist,
$Q(G_{Remote})$ der Gasmengenstrom, in Standard-Liter pro Minute (SLM), des dem Plasma zugeführten Trägergases $G_{Remote}$ ist,

- 

$$0,01 \text{ SLM/kW} \leq Q(Precursor) / P_m \leq 1,0 \text{ SLM/kW}$$

wobei

$P_m$ die mittlere Leistung in kW ist, die während des Verfahrens in die Plasma-erzeugende Einheit eingespeist wird,
Q(Precursor) der Gasmengenstrom, in Standard-Liter pro Minute (SLM), des Precursors ist, mit dem dieser dem Plasma zugeführt wird.

Das erfindungsgemäße Beschichtungsverfahren erfolgt über PECVD (d.h. eine Plasma-unterstützte chemische Gasphasenabscheidung) bei Atmosphärendruck. Wie einleitend bereits erwähnt, bezieht sich bei einem AP-PECVD-Verfahren die Angabe "Atmosphärendruck" auf den Druck, dem das zu beschichtende Substrat kurz vor der Beschichtung ausgesetzt ist (also der Startdruck). Als Atmosphärendruck wird im Rahmen der vorliegenden Erfindung ein Druck von 1,0 +/- 0,1 bar angesehen. Aufwendige Maßnahmen zur Herstellung und Aufrechterhaltung eines Vakuums entfallen daher. Eine bei Atmosphärendruck arbeitende Plasmaquelle lässt sich direkt in die Fertigungslinie integrieren. Weiterhin wird das Verfahren im Remote-Betrieb durchgeführt. Der Precursor wird nicht der Plasma-erzeugenden Einheit, sondern ausschließlich dem bereits erzeugten Plasma zugegeben (z.B. am Ausgang der Plasma-erzeugenden Einheit). Im Remote-Betrieb kommt das zu beschichtende Trägermaterial nicht direkt mit der Plasmaquelle in Berührung, was die Gefahr einer Schädigung des Trägermaterials reduziert.

Im Rahmen der vorliegenden Erfindung wurde überraschend erkannt, dass eine poröse Schicht mit ausgeprägter Haftvermittlerwirkung über ein PECVD-Verfahren bei Atmosphärendruck im Remote-Betrieb erhältlich ist, wenn eine relativ hohe Konzentration des Precursors verwendet wird. Dies ist überraschend, weil bei einer so hohen Precursor-Konzentration, wie sie im erfindungsgemäßen Verfahren verwendet wird, zu vermuten wäre, dass die Moleküle des Precursors bereits frühzeitig, d.h. in deutlichem Abstand zu dem zu beschichtenden Trägermaterial, in der Gasphase in signifikantem Umfang miteinander reagieren (z.B. unter Bildung größerer Pulverpartikel) und die Ausbildung eines auf der Oberfläche haftenden Films nicht mehr stattfindet. Weiterhin wurde im Rahmen der vorliegenden Erfindung erkannt, dass die Bildung der porösen Schicht mit hoher Haftvermittlerwirkung sehr effizient verläuft, wenn die mittlere Leistung $P_m$, die während der Beschichtung in die Plasma-erzeugende Einheit eingespeist wird, und der Gasmengenstrom Q(Precursor) des Precursors der oben angegebenen Bedingung genügen.

Wie nachfolgend noch eingehender beschrieben wird, ist die über das erfindungsgemäße Verfahren hergestellte Beschichtung porös mit Poren im Nanometer-Bereich und stellt einen sehr effektiven Haftvermittler zwischen dem Trägermaterial und einem weiteren Material dar. Wird dieses weitere Material (z.B. ein Thermoplast, ein Harzsystem oder eine Lösung) in flüssiger Form auf die poröse Beschichtung des Trägermaterials aufgebracht, dringt es in diese Poren ein und zeigt nach seiner Verfestigung primär durch nano-formschlüssige Verzahnung eine sehr hohe Haftfestigkeit auf dem Trägermaterial. Ein Ätzen des Trägermaterials ist nicht erforderlich.

Die mit dem erfindungsgemäßen Verfahren hergestellte Beschichtung weist Poren mit Hinterschnitten auf. Diese Porengeometrie trägt zu der Realisierung einer sehr hohen Haftfestigkeit bei.

Die relativ hohe Konzentration des Precursors wird über das folgende Verhältnis angegeben:

$$Q(Precursor) / [Q(G_{Plasma}) + Q(G_{Remote})] \geq 1 / 2200$$

wobei

Q(Precursor) der Gasmengenstrom, in Standard-Liter pro Minute (SLM), des dem Plasma zugeführten Precursors ist,
$Q(G_{Plasma})$ der Gasmengenstrom, in Standard-Liter pro Minute (SLM), des in die Plasma-erzeugende Einheit eingeleiteten Precursor-freien Gases $G_{Plasma}$, ist,
$Q(G_{Remote})$ der Gasmengenstrom, in Standard-Liter pro Minute (SLM), des dem Plasma zugeführten Trägergases $G_{Remote}$ ist.

Bevorzugt gilt:

$$Q(Precursor) / [Q(G_{Plasma}) + Q(G_{Remote})] \geq 1 / 1500;$$

noch bevorzugter gilt:

$$Q(Precursor) / [Q(G_{Plasma}) + Q(G_{Remote})] \geq 1 / 800.$$

In einer bevorzugten Ausführungsform gilt:

$$1 / 50 \geq Q(Precursor) / [Q(G_{Plasma}) + Q(G_{Remote})] \geq 1 / 2200;$$

bevorzugter gilt:

$$1 / 100 \geq Q(Precursor) / [Q(G_{Plasma}) + Q(G_{Remote})] \geq 1 / 1500;$$

noch bevorzugter gilt:

$$1 / 200 \geq Q(Precursor) / [Q(G_{Plasma}) + Q(G_{Remote})] \geq 1 / 800$$

Wie oben ausgeführt, werden die mittlere Leistung $P_m$, in kW, die während des Verfahrens in die Plasma-erzeugende Einheit eingespeist wird, und der Gasmengenstrom Q(Precursor) des Precursors, in Standard-Liter/Minute, so eingestellt, dass sie der folgenden Bedingung genügen:

$$0{,}01 \leq Q(Precursor) / P_m \leq 1{,}0$$

Wird ein zu hoher Wert für das Verhältnis $Q(Precursor) / P_m$ gewählt, so kann dies dazu führen, dass nur einzelne Agglomerate, jedoch keine zusammenhängende Beschichtung auf dem Trägermaterial abgeschieden werden. Ein zu geringer Wert für das Verhältnis $Q(Precursor) / P_m$ kann dazu führen, dass dichte Schichten ohne Porosität erhalten werden.

In einer bevorzugten Ausführungsform gilt:

$$0{,}05 \leq Q(Precursor) / P_m \leq 0{,}9$$

bevorzugter gilt:

$$0,05 \leq Q(Precursor) / P_m \leq 0,7$$

noch bevorzugter gilt:

$$0,1 \leq Q(Precursor) / P_m \leq 0,5$$

Wird das PECVD-Verfahren im Pulsbetrieb durchgeführt, ergibt sich die mittlere Leistung $P_m$, die während des Verfahrens in die Plasma-erzeugende Einheit eingespeist wird, durch folgende Beziehung:

$$P_m = [P(Puls) * t(Puls) + P(Pause) * t(Pause)] / (t(Puls) + t(Pause))$$

wobei

P(Puls) die Leistung ist, die während der Pulse eingespeist wird,
P(Pause) die Leistung ist, die zwischen den Pulsen eingespeist wird,
t(Puls) die Zeitdauer der Pulse ist,
t(Pause) die Zeitdauer zwischen den Pulsen ist.

PECVD-Anlagen, die bei Atmosphärendruck und im Remote-Betrieb arbeiten, sind dem Fachmann bekannt. Im Rahmen der vorliegenden Erfindung wird die Remote-AP-PECVD-Anlage mit einer relativ hohen Precursor-Konzentration betrieben, so dass die oben definierte Bedingung hinsichtlich der Gasmengenströme erfüllt wird. Die Plasma-erzeugende Einheit einer PECVD-Anlage umfasst beispielsweise neben den Mitteln zur Erzeugung eines Plasmas noch eine Plasmadüse, durch die das erzeugte Plasma die Plasma-erzeugende Einheit verlässt.

Das erfindungsgemäße PECVD-Verfahren kann im Pulsbetrieb (d.h. mit einer gepulsten Leistungszufuhr in die Plasma-erzeugende Einheit)) oder auch kontinuierlich (d.h. mit kontinuierlicher Leistungszufuhr in die Plasma-erzeugende Einheit) oder in einer Kombination beider Varianten durchgeführt werden. Diese möglichen Varianten für den Betrieb einer PECVD-Anlage sind dem Fachmann bekannt.

Die Gasmengenströme des Precursors (Q(Prec)), des Trägergases (Q($G_{Remote}$)) und des der Plasma-erzeugenden Einheit zugeführte Precursor-freie Gas (Q($G_{Plasma}$)) können für sich betrachtet über einen breiten Bereich variieren (z.B. in Abhängigkeit von der Größe bzw. den Abmessungen der PECVD-Vorrichtung). Wichtig ist jedoch, dass die Gasmengenströme in der oben definierten Weise aufeinander abgestimmt sind.

Sofern das Trägergas $G_{Remote}$ und/oder das Plasmagas $G_{Plasma}$ zwei oder mehr Gase enthalten, ergeben sich die jeweiligen Gasmengenströme Q($G_{Remote}$) und Q($G_{Plasma}$) aus der Summe der Gasmengenströme der einzelnen Gase.

Sofern der Precursor zwei oder mehr Verbindungen enthält, ergibt sich der Gasmengenstrom Q(Prec) des Precursors aus der Summe der Gasmengenströme der einzelnen Verbindungen.

Precursoren, die im Rahmen einer Beschichtung durch eine plasmaunterstützte Gasphasenabscheidung verwendet werden können, sind dem Fachmann bekannt. Der Precursor kann eine einzelne Verbindung oder auch ein Gemisch aus zwei oder mehr Verbindungen sein.

Der Precursor ist beispielsweise eine Organosilicium-Verbindung, eine Organometall-Verbindung, ein Monomer eines organischen Polymers, oder ein Gemisch aus mindestens zwei dieser Verbindungen.

Die Organosilicium-Verbindung ist beispielsweise ein Siloxan, ein Tetraalkoxysilan, ein Alkyltrialkoxysilan, ein Silan, ein Silazan, oder ein Gemisch aus mindestens zwei dieser Verbindungen.

Die Organosilicium-Verbindung ist beispielsweise Hexamethyldisiloxan (HMDSO), Tetramethyldisiloxane (TMDSO), Tetraethylorthosilicat (TEOS), Tetramethylsilan (TMS), Tetramethylcyclotetrasiloxan (TMCTS), Octamethylcyclotetrasiloxan (OMCTS), Hexamethycyclotrisiloxan (HMCTS) oder ein Gemisch aus mindestens zwei dieser Verbindungen.

Das Monomer eines organischen Polymers ist beispielsweise Acrylsäure, Methacrylsäure, Metan, Ethan, Ethylen, ein alpha-Olefin wie Propylen oder Styrol.

Die Organometallverbindung ist beispielsweise ein Alkoholat, ein Acetylacetonat, eine Carbonylverbindung oder eine Alkylverbindung eines Metalls (z.B. Ti, Zn, Sn, Ta, etc.).

Geeignete Trägergase $G_{Remote}$, die zusammen mit dem Precursor dem bereits erzeugten Plasma im Remote-Betrieb zugeführt werden können, sind dem Fachmann bekannt. Das Trägergas $G_{Remote}$ kann inerte und/oder reaktive (z.B. oxidative) Gase enthalten. Beispielsweise enthält das Trägergas $G_{Remote}$ Stickstoff ($N_2$), Sauerstoff ($O_2$), Luft (z.B. komprimierte Luft), ein Edelgas (z.B. Argon), $CO_2$, $H_2$ oder ein Gemisch aus mindestens zwei dieser Gase.

Geeignete Gase $G_{Plasma}$, die der Plasma-erzeugenden Einheit zugeführt und dort zum Plasma gezündet werden, sind dem Fachmann ebenfalls bekannt. Es können z.B. die Gase verwendet werden, die auch als Trägergase $G_{Remote}$ zum Einsatz kommen. Das der Plasmakammer zugeführte Gas $G_{Plasma}$ kann inerte und/oder reaktive (z.B. oxidative) Gase enthalten. Beispielsweise enthält das der Plasmakammer zugeführte Gas $G_{Plasma}$ Stickstoff ($N_2$), Sauerstoff ($O_2$), Luft (z.B. komprimierte Luft), ein Edelgas (z.B. Argon) oder ein Gemisch aus mindestens zwei dieser Gase.

Das Plasma kann über Methoden, die dem Fachmann bekannt sind, in der Plasma-erzeugenden Einheit gezündet werden. Beispielsweise kann das Plasma durch Einwirkung eines elektromagnetischen Feldes, z.B. mit einer Frequenz im Hochfrequenz- oder Mikrowellenbereich ("Mikrowellen-Plasma") erzeugt werden. Eine weitere Möglichkeit ist die Verwendung von hochfrequenter Hochspannung (Lichbogen) Coronaentladungen oder Barriereentladungen.

Wie oben bereits ausgeführt, wird der Precursor ausschließlich dem bereits erzeugten Plasma zugeführt, während das der Plasmakammer zugeführte Gas $G_{Plasma}$ Precursorfrei ist.

Beispielsweise werden der Precursor und das Trägergas $G_{Remote}$ am Ausgang der Plasmakammer dem Plasma zugeführt.

Der Precursor wird beispielsweise zuerst in die Gasphase (z.B. durch Erwärmen) gebracht und mit einemTrägergas transportiert.

Es hat sich überraschenderweise auch gezeigt, dass die Ausbildung einer porösen Schicht anstelle einer dichten Schicht noch besser unterstützt wird, wenn die Beschichtung bei einer relativ geringen Flächenrate $v_F$ (beschichtete Fläche pro Zeiteinheit) erfolgt. Die Flächenrate der Beschichtung lässt sich in bekannter Weise über die Beschichtungsbreite der Plasmadüse und die Geschwindigkeit, mit der das zu beschichtende Trägermaterial relativ zur Plasmadüse bewegt wird, einstellen. Die Beschichtungsbreite der Plasmadüse wird auch als Arbeitsbreite ("working width") bezeichnet.

In einer bevorzugten Ausführungsform genügen der Gasmengenstrom Q(Precursor) des Precursors und die Flächenrate der Beschichtung der folgenden Bedingung:

$$Q(Precursor) / v_F > 0{,}1 \text{ Standardliter SL/m}^2, \text{ bevorzugter bei} > 1 \text{ SL/m}^2,$$

wobei

Q(Precursor) der Gasmengenstrom, in Standard-Liter pro Minute (SLM), des Precursors ist, mit dem dieser dem Plasma zugeführt wird
$v_F$ die beschichtete Fläche pro Zeiteinheit ist.

Wie oben bereits erwähnt, lässt sich die pro Zeiteinheit beschichtete Fläche in bekannter Weise über die Beschichtungsbreite der Plasmadüse und die Geschwindigkeit, mit der das zu beschichtende Trägermaterial relativ zur Plasmadüse bewegt wird, einstellen.

In einer bevorzugten Ausführungsform gilt:

1

$$1 \text{ SL/m}^2 \leq Q(Precursor) / v_F \leq 30 \text{ SL/m}^2,$$

bevorzugter gilt:
2

$$2 \text{ SL/m}^2 \leq Q(Precursor) / v_F \leq 20 \text{ SL/m}^2.$$

Der Abstand zwischen dem Ausgang der Plasma-erzeugenden Einheit und der zu beschichtenden Oberfläche des Trägermaterials liegt beispielsweise im Bereich von 2-50 mm, bevorzugter 3-30 mm oder 5-20 mm.

Das Trägermaterial umfasst ein Substrat, das optional noch mit einer ein- oder mehrlagigen Beschichtung versehen ist.

Substrate bzw. Trägermaterialien, die für ein plasmaunterstütztes chemisches Gasphasenabscheidungsverfahren (PECVD) geeignet sind, sind dem Fachmann grundsätzlich bekannt.

Bei dem Substrat kann es sich z.B. um ein Metallsubstrat, Kunststoffsubstrat, Keramiksubstrat, Glassubstrat, Kohlenstoffsubstrat, oder eine Kombination von mindestens zwei dieser Substratmaterialien handeln. In Abhängigkeit vom spezifischen Verwendungszweck kann das Substrat z.B. eine starre Platte , eine flexible Folie oder ein komplexes 3D-Bauteil sein.

Optional können auf dem Substrat eine oder mehrere Schichten aufgebracht sein. Dabei kann es sich um eine oder mehrere Funktionsschichten (z.B. zur Optimierung von Eigenschaften wie Haftung, Härte, Optik, Leitfähigkeit etc.) bzw. auch strukturierte oder texturierte Schichten (erhältlich z.B. durch Lithographie, Prägen, Ätzen oder auch durch vakuumtechnische Verfahren wie Sputtern, PECVD oder Plasmaätzen) handeln.

Diese zusätzlichen Schichten können auf dem Substrat durch herkömmliche, dem Fachmann bekannte Beschichtungsverfahren aufgebracht werden. Beispielsweise können eine oder mehrere dieser optionalen Schichten durch PECVD aufgebracht werden.

Die vorliegende Erfindung betrifft außerdem ein beschichtetes Trägermaterial, das über das oben beschriebene Verfahren erhältlich ist.

Weiterhin betrifft die vorliegende Erfindung ein Verfahren zum Verbinden eines Trägermaterials mit einem weiteren Material, wobei

- das Trägermaterial gemäß dem oben beschriebenen Verfahren beschichtet wird,
- das weitere Material oder eine Vorstufe davon in flüssiger Form auf das beschichtete Trägermaterial aufgebracht wird.

Die über das erfindungsgemäße Verfahren hergestellte Beschichtung stellt einen sehr effektiven Haftvermittler zwischen dem Trägermaterial und einem weiteren Material dar. Wird dieses weitere Material oder eine Vorstufe davon in flüssiger Form auf die poröse Beschichtung des Trägermaterials aufgebracht, dringt es in diese Poren ein und zeigt nach seiner Verfestigung eine sehr hohe Haftfestigkeit auf dem Trägermaterial. Ein Ätzen des Trägermaterials ist nicht erforderlich. Die mit dem erfindungsgemäßen Verfahren hergestellte Beschichtung weist Poren mit Hinterschnitten auf. Diese Porengeometrie trägt nach der Infiltrierung mit dem weiteren Material wesentlich zu der Realisierung einer sehr hohen Haftfestigkeit bei.

Hinsichtlich geeigneter Trägermaterialien kann auf die obigen Ausführungen verwiesen werden.

Bei dem weiteren Material, das in flüssiger Form auf die Haftvermittlerschicht aufgebracht wird, kann es sich beispielsweise um ein Polymer, ein Metall bzw. eine Metalllegierung, ein anorganisches Material, ein organisch-anorganisches Hybridmaterial, oder ein Gemisch davon handeln. Das Material kann beispielsweise als Schmelze, als flüssige reaktive Monomere oder in gelöster Form aufgebracht werden. Nach dem Aufbringen in flüssiger Form wird das Material oder dessen Vorstufe verfestigt (z.B. durch Erstarren oder Kristallisieren des geschmolzenen Materials; durch Verdunstung des Lösungsmittels, in dem das weitere Material gelöst war; durch eine Vernetzungsreaktion der Vorstufe des weiteren Materials; .... etc.).

Bei dem Polymer kann es sich beispielsweise um einen Thermoplasten, einen Duroplasten, ein Elastomer, oder Gemische dieser Polymere handeln. Geeignet sind alle Polymere, die schmelzbar sind, in einer Vorstufe flüssig vorliegen oder in einem verdampfbaren Lösungsmittel gelöst werden können z.B. aus einem Polyolefin, einem Epoxidharz, Polyurethan, Polyester, einem Fluorpolymer, einem Polyamid, einem Polyacrylat, Polymethacrylat, Polycarbonat, Polyphenylsulfid, Polyetheretherketone, Gummi, Kautschuk, thermoplastisches Elastomer (TPO) oder Gemischen dieser Polymere ausgewählt werden. Ebenso sind Compounds aus einem verflüssigbaren Anteil und festen Füllstoffen verwendbar (z.B. glasfaserverstärkte oder Kohlenstoffpartikel-gefüllte Kunststoffe).

Ein anorganisches Material oder ein organisch-anorganisches Hybridmaterial kann beispielsweise aufgebracht werden, indem zunächst eine geeignete flüssige Vorstufe bzw. Precursor-Verbindung auf die Haftvermittlerschicht aufgebracht wird und diese flüssige Vorstufe, nachdem sie ausreichend tief in die Spalten bzw. Kavitäten der Haftvermittlerschicht eingedrungen ist, durch geeignete Verfahrensschritte wie z.B. einen Sol-Gel-Prozess verfestigt bzw. ausgehärtet wird.

Bei der flüssigen Vorstufe eines Polymermaterials kann es sich z.B. um organische Ausgangsverbindungen (Monomere) handeln, die erst noch einer Polymerisation bzw. Vernetzung unterzogen werden müssen, um die Polymerkomponente zu bilden.

Die Verfestigung des flüssigen Polymermaterials bzw. der flüssigen Vorstufe eines Polymermaterials kann z.B. durch Temperaturänderung (z.B. Abkühlen der Polymerschmelze oder auch Temperaturerhöhung zur Aushärtung eines Harzes oder Vulkanisats) erfolgen.

Bei der flüssigen Vorstufe des anorganischen Materials oder des organisch-anorganischen Hybridmaterials kann es sich beispielsweise um solche Verbindungen handeln, die sich über einen Sol-Gel-Prozess zu dem anorganischen Material bzw. dem organisch-anorganischen Hybridmaterial umsetzen lassen.

Um eine möglichst gute Benetzung mit dem weiteren Material bzw. dessen Vorstufe zu erzielen, kann es bevorzugt sein, dass vor dem in Kontakt bringen des nanostrukturierten Schichtsystems mit dem Material oder der Vorstufe des Materials eine weitere Schicht, z.B. durch PECVD, auf dem nanostrukturierten Schichtsystem aufgebracht wird, deren Oberflächenenergie an das anschließend aufzubringende Material bzw. die anschließend aufzubringende Vorstufe des Materials angepasst ist.

Nach seiner Verfestigung (z.B. durch Erstarren oder Kristallisieren des geschmolzenen Materials; durch Verdunstung des Lösungsmittels, in dem das weitere Material gelöst war; durch eine Vernetzungsreaktion der Vorstufe des weiteren Materials; .... etc.) zeigt das weitere Material unter Vermittlung der Haftvermittlerschicht eine sehr hohe Haftfestigkeit auf dem Trägermaterial.

Die Erfindung wird anhand der nachfolgenden Beispiele eingehender beschrieben.

**Beispiele**

In den Beispielen wurde eine PECVD-Anlage verwendet, die bei Atmosphärendruck und im Remote-Betrieb arbeitete (d.h. der Precursor (zusammen mit dem Trägergas) wurde ausschließlich dem bereits erzeugten Plasma zugeführt, während in die Plasma-erzeugende Einheit ein Precursor-freies Gas eingeleitet wurde). Das Plasma wurde durch eine hochfrequente Hochspannung erzeugt, Leistung. Für die Beispiele 1 und 2 galten folgende Bedingungen: 900 W bei 21 kHz und einem 1:1 Puls-Pause-Verhältnis, so dass sich eine mittlere Leitung $P_m$ von 0,45 kW ergab. Für das Vergleichsbeispiel galten folgende Bedingungen: 900 W bei 21 kHz und einem 1:9 Puls-Pause-Verhältnis, so dass sich eine mittlere Leistung $P_m$ von 0,09 kW ergab.

Beispiel 1

In Beispiel 1 wurde ein Glassubstrat als zu beschichtendes Trägermaterial verwendet. Eine Ätzbehandlung der Glasoberfläche fand nicht statt. Es wurde also eine glatte Glasoberfläche beschichtet. Die Beschichtungsbreite der Plasmadüse (Arbeitsbreite) betrug 3 mm und die Geschwindigkeit des zu beschichtenden Trägermaterials gegenüber der Plasmadüse betrug 2,0 m/min.

Weitere Verfahrensparameter sind in der nachfolgenden Tabelle I angegeben:

Tabelle I: Verfahrensparameter in Beispiel 1

| Precursor: | Hexamethyldisiloxan (HMDSO) |
|---|---|
| Gasmengenstrom Q(Precursor) des Precursors; [SLM]: | 0,092 |
| Trägergas $G_{Remote}$: | Druckluft |
| Gasmengenstrom Q($G_{Remote}$); [SLM]: | 5 |
| Gas $G_{Plasma}$, das der Plasma-erzeugenden Einheit zugeführt wurde: | $N_2$ |
| Gasmengenstrom Q($G_{Plasma}$); [SLM]: | 40 |
| Q(Prec) / [Q($G_{Remote}$)+Q($G_{Plasma}$)]: | 1 / 489 |
| Mittlere Leistung $P_m$ [kW] | 0,450 |
| Q(Precursor) / $P_m$ [SLM/kW] | 0,20 |

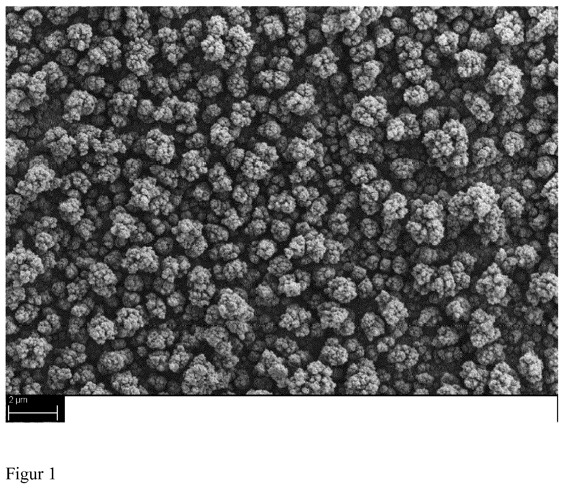

Figur 1 zeigt eine REM-Aufnahme der in Beispiel 1 erhaltenen Beschichtung (in Draufsicht). Wie die REM-Aufnahme belegt, führt das erfindungsgemäße Verfahren zu einer hochporösen Schicht. Die in Beispiel 1 erhaltene Schicht besteht aus Agglomeraten, die einen gewissen Abstand im Nanometer-Bereich aufweisen, wodurch eine nanoporöse Struktur erhalten wird.

Beispiel 2

In Beispiel 2 wurde wiederum ein Glassubstrat als zu beschichtendes Trägermaterial verwendet. Eine Ätzbehandlung der Glasoberfläche fand nicht statt. Es wurde also eine glatte Glasoberfläche beschichtet. Die Beschichtungsbreite der Plasmadüse

(Arbeitsbreite) betrug 3 mm und die Geschwindigkeit des zu beschichtenden Trägermaterials gegenüber der Plasmadüse betrug 2,0 m/min.

Weitere Verfahrensparameter sind in der nachfolgenden Tabelle II angegeben:

Tabelle II: Verfahrensparameter in Beispiel 2

| Precursor: | Hexamethyldisiloxan (HMDSO) |
|---|---|
| Gasmengenstrom Q(Precursor) des Precursors; [SLM]: | 0,092 |
| Trägergas $G_{Remote}$: | Druckluft |
| Gasmengenstrom Q($G_{Remote}$); [SLM]: | 5 |
| Gas $G_{Plasma}$, das der Plasma-erzeugenden Einheit zugeführt wurde: | Druckluft |
| Gasmengenstrom Q($G_{Plasma}$); [SLM]: | 40 |
| Q(Prec) / [Q($G_{Remote}$)+Q($G_{Plasma}$)]: | 1 / 489 |
| Mittlere Leistung $P_m$ [kW] | 0,450 |
| Q(Precursor) / $P_m$ [SLM/kW] | 0,20 |

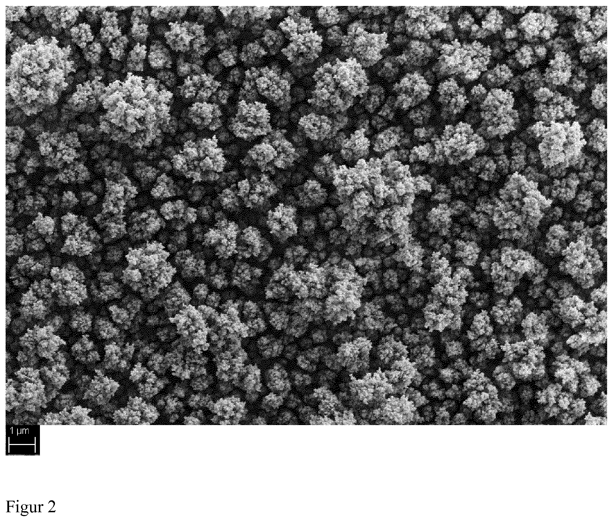

Figur 2 zeigt eine REM-Aufnahme der in Beispiel 2 erhaltenen Beschichtung (in Draufsicht). Wie die REM-Aufnahme belegt, führt das erfindungsgemäße Verfahren zu einer hochporösen Schicht. Die in Beispiel 2 erhaltene Schicht besteht aus Agglomeraten, die einen gewissen Abstand im Nanometer-Bereich aufweisen, wodurch eine nanoporöse Struktur erhalten wird.

In den erfindungsgemäßen Beispielen 1 und 2 wurde eine relativ hohe Konzentration des Precursors (ersichtlich an dem hohen Wert für Q(Prec) / [Q($G_{Remote}$)+Q($G_{Plasma}$)] eingesetzt. In dem von J. Haag et al. beschriebenen PECVD-Verfahren (Journal of Materials Science and Engineering A 5 (7-8), 2015, 274-284, doi: 10.17265/2161-6213/2015.7-8.004), das ebenfalls unter Atmosphärendruck und im Remote-Betrieb durchgeführt wurde, ergibt sich folgendes Verhältnis für die Gasmengenströme:

$$Q(Prec) / [Q(G_{Remote})+Q(G_{Plasma})] = 1/7826$$

Wie oben bereits erwähnt, wäre bei einer so hohen Precursor-Konzentration, wie sie im erfindungsgemäßen Verfahren verwendet wird, eigentlich zu erwarten gewesen, dass die Moleküle des Precursors bereits frühzeitig, d.h. in deutlichem Abstand zu dem zu beschichtenden Trägermaterial, in der Gasphase in signifikantem Umfang miteinander reagieren (z.B. unter Bildung größerer Pulverpartikel) und die Ausbildung eines auf der Oberfläche haftenden Films nicht mehr stattfindet.

Vergleichsbeispiel 1

In Vergleichsbeispiel 1 wurde wiederum ein Glassubstrat als zu beschichtendes Trägermaterial verwendet. Eine Ätzbehandlung der Glasoberfläche fand nicht statt. Es wurde also eine glatte Glasoberfläche beschichtet. Die Beschichtungsbreite der Plasmadüse (Arbeitsbreite) betrug 3 mm und die Geschwindigkeit des zu beschichtenden Trägermaterials gegenüber der Plasmadüse betrug 5,0 m/min.

Weitere Verfahrensparameter sind in der nachfolgenden Tabelle III angegeben:

Tabelle III: Verfahrensparameter in Vergleichsbeispiel 1

| Precursor: | Hexamethyldisiloxan (HMDSO) |
|---|---|
| Gasmengenstrom Q(Precursor) des Precursors; [SLM]: | 0,092 |
| Trägergas $G_{Remote}$: | Druckluft |
| Gasmengenstrom Q($G_{Remote}$); [SLM]: | 5 |
| Gas $G_{Plasma}$, das der Plasma-erzeugenden Einheit zugeführt wurde: | $N_2$ |
| Gasmengenstrom Q($G_{Plasma}$); [SLM]: | 40 |
| Q(Prec) / [Q($G_{Remote}$)+Q($G_{Plasma}$)]: | 1 / 489 |
| Mittlere Leistung $P_m$ [kW] | 0,090 |
| Q(Precursor) / $P_m$ [SLM/kW] | 1,02 |

In Vergleichsbeispiel 1 wurde gegenüber Beispiel 1 eine geringere mittlere Leistung in die Plasma-erzeugende Einheit eingespeist. Somit ergibt sich im Vergleich zu Beispiel 1 ein höherer Wert für das Verhältnis Q(Precursor) / $P_m$.

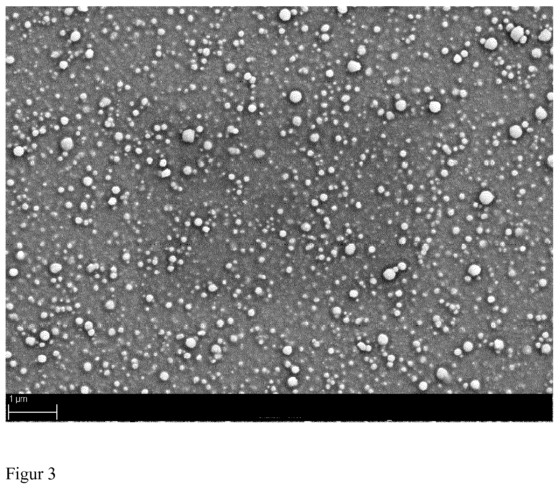

Figur 3 zeigt eine REM-Aufnahme der in Vergleichsbeispiel 1 erhaltenen Beschichtung (in Draufsicht). In Vergleichsbeispiel 1 haben sich auf der Oberfläche zwar viele Agglomerate gebildet, die jedoch überwiegend isoliert vorliegen und daher keine durchgehende Beschichtung ausbilden bzw. keine Verzahnungsstellen mit Hinterschnitt bereitstellen.

Testen der mit der Haftvermittlerschicht realisierbaren Haftfestigkeit

Auf die in Beispiel 1 erhaltene Probe wurde geschmolzenes Polypropylen aufgebracht. Die Schmelze drang in die nanoporöse Haftvermittlerschicht ein. Nach der Verfestigung der Schmelze liegt ein Trägermaterial/Polypropylen-Verbund vor, der eine extrem hohe Haftfestigkeit aufweist. Beim Anlegen hoher Abzugskräfte kommt es zu einem Kohäsionsversagen innerhalb des Polypropylens, nicht jedoch an der Grenzfläche Trägermaterial/Haftvermittlerschicht/Polypropylen.

Es wurden also Haftwerte realisiert, die im Bereich der inneren Kohäsion von PP liegen. Wird das PP direkt auf Metall oder Glas aufgebracht, so beträgt die Haftfestigkeit nahezu null.

**Patentansprüche**

1. Verfahren zum Beschichten eines Trägermaterials, wobei die Beschichtung über eine plasmaunterstützte chemische Gasphasenabscheidung bei Atmosphärendruck erfolgt, wobei

   - die Zündung des Plasmas in einer Plasma-erzeugenden Einheit, in die ein Precursor-freies Gas $G_{Plasma}$ eingeleitet wird, erfolgt,
   - der Precursor mit einem Trägergas $G_{Remote}$ dem bereits erzeugten Plasma zugeführt wird,
   -

   $$Q(\text{Precursor}) / [Q(G_{Plasma}) + Q(G_{Remote})] \geq 1 / 2200$$

   wobei

   Q(Precursor) der Gasmengenstrom, in Standard-Liter pro Minute, des dem Plasma zugeführten Precursors ist,
   Q($G_{Plasma}$) der Gasmengenstrom, in Standard-Liter pro Minute, des in die Plasma-erzeugende Einheit eingeleitet Precursor-freien Gases $G_{Plasma}$, ist,
   Q($G_{Remote}$) der Gasmengenstrom, in Standard-Liter pro Minute, des dem Plasma zugeführten Trägergases $G_{Remote}$ ist,

   -

   $$0,01 \leq Q(\text{Precursor}) / P_m \leq 1,0$$

   wobei

   $P_m$ die mittlere Leistung in kW ist, die während des Verfahrens in die Plasma-erzeugende Einheit eingespeist wird,
   Q(Precursor) der Gasmengenstrom, in Standard-Liter pro Minute, des dem Plasma zugeführten Precursors ist.

2. Verfahren nach Anspruch 1, wobei der Precursor eine Organosilicium-Verbindung, eine Organometall-Verbindung, ein Monomer eines organischen Polymers, oder ein Gemisch aus mindestens zwei dieser Verbindungen ist.

3. Verfahren nach Anspruch 1 oder 2, wobei das Trägergas $G_{Remote}$ und/oder das der Plasma-erzeugenden Einheit zugeführte Gas $G_{Plasma}$ Stickstoff ($N_2$), Sauerstoff ($O_2$), Luft, $CO_2$, ein Edelgas oder ein Gemisch aus mindestens zwei dieser Gase ist.

4. Verfahren nach einem der vorstehenden Ansprüche, wobei der Gasmengenstrom Q(Precursor) des Precursors und die pro Zeiteinheit beschichtete Fläche $v_F$ des Trägermaterials der folgenden Bedingung genügen:

$$Q(Precursor) / v_F > 0,1 \text{ Standard-Liter} / m^2.$$

5. Verfahren nach einem der vorstehenden Ansprüche, wobei das Trägermaterial ein Metallsubstrat, ein Kunststoffsubstrat, ein Keramiksubstrat, ein Glassubstrat, ein Kohlenstoffsubstrat, oder eine Kombination von mindestens zwei dieser Substrate enthält.

6. Verfahren zum Verbinden eines Trägermaterials mit einem weiteren Material, wobei

   - das Trägermaterial gemäß einem der Ansprüche 1-5 beschichtet wird,
   - das weitere Material oder eine Vorstufe davon in flüssiger Form auf das beschichtete Trägermaterial aufgebracht wird.

7. Verfahren nach Anspruch 6, wobei das weitere Material ein Polymer, ein Metall oder eine Metalllegierung, ein anorganisches Material, ein organisch-anorganisches Hybridmaterial, oder ein Gemisch davon ist.

Figur 1

Figur 2

Figur 3

Europäisches
Patentamt

European
Patent Office

Office européen
des brevets

## EUROPÄISCHER RECHERCHENBERICHT

Nummer der Anmeldung

EP 19 15 7492

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | DE 603 14 634 T2 (SAINT GOBAIN [FR]) 6. März 2008 (2008-03-06) * Absatz [0033] * * Absatz [0029] * * Absatz [0044] * ----- | 1-7 | INV. C23C16/455 C23C16/503 C23C16/515 C23C16/452 C23C16/40 |
| X | DE 199 58 474 A1 (BOSCH GMBH ROBERT [DE]) 21. Juni 2001 (2001-06-21) * Spalte 2, Zeile 29 - Zeile 33 * * Spalte 6, Zeile 5 * * Spalte 5, Zeile 57 - Spalte 6, Zeile 3 * ----- | 1-3 | C23C16/513 H01J37/32 |
| X | US 2008/014445 A1 (HICKS ROBERT F [US] ET AL) 17. Januar 2008 (2008-01-17) * Absatz [0030] - Absatz [0036]; Abbildung 1 * * Absatz [0042] * * Absatz [0046] * * Absatz [0036] * * Absatz [0050] * ----- | 1-3,5-7 | |
| A | WO 2008/120505 A1 (KONICA MINOLTA HOLDINGS INC [JP]; KONDO YOSHIKAZU [JP] ET AL.) 9. Oktober 2008 (2008-10-09) * das ganze Dokument * ----- | 1-7 | RECHERCHIERTE SACHGEBIETE (IPC) C23C H01J |

Der vorliegende Recherchenbericht wurde für alle Patentansprüche erstellt

| Recherchenort | Abschlußdatum der Recherche | Prüfer |
|---|---|---|
| Den Haag | 4. Juli 2019 | Kudelka, Stephan |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

................................................................
& : Mitglied der gleichen Patentfamilie, übereinstimmendes Dokument

EPO FORM 1503 03.82 (P04C03)

## ANHANG ZUM EUROPÄISCHEN RECHERCHENBERICHT
## ÜBER DIE EUROPÄISCHE PATENTANMELDUNG NR.

EP 19 15 7492

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

04-07-2019

| Im Recherchenbericht angeführtes Patentdokument | Datum der Veröffentlichung | Mitglied(er) der Patentfamilie | Datum der Veröffentlichung |
|---|---|---|---|
| DE 60314634 T2 | 06-03-2008 | AT 365816 T | 15-07-2007 |
| | | AU 2003260448 A1 | 23-02-2004 |
| | | CN 1675403 A | 28-09-2005 |
| | | DE 60314634 T2 | 06-03-2008 |
| | | EP 1525336 A2 | 27-04-2005 |
| | | ES 2289331 T3 | 01-02-2008 |
| | | JP 4417840 B2 | 17-02-2010 |
| | | JP 2006503686 A | 02-02-2006 |
| | | KR 20050030215 A | 29-03-2005 |
| | | US 2006141290 A1 | 29-06-2006 |
| | | WO 2004013376 A2 | 12-02-2004 |
| DE 19958474 A1 | 21-06-2001 | DE 19958474 A1 | 21-06-2001 |
| | | EP 1252365 A1 | 30-10-2002 |
| | | JP 2003515676 A | 07-05-2003 |
| | | WO 0140543 A1 | 07-06-2001 |
| US 2008014445 A1 | 17-01-2008 | US 2008014445 A1 | 17-01-2008 |
| | | WO 2006002429 A2 | 05-01-2006 |
| WO 2008120505 A1 | 09-10-2008 | JP WO2008120505 A1 | 15-07-2010 |
| | | WO 2008120505 A1 | 09-10-2008 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102012220286 A1
- EP 2572876 A1
- DE 102011086399 A1

**In der Beschreibung aufgeführte Nicht-Patentliteratur**

- **U. STÖHR.** Surface Activation of Plastics by Plasma for Adhesion Promotion. *WOMag,* 2016, vol. 5, 15-17
- **J. HAAG et al.** *Journal of Materials Science and Engineering,* 2015, vol. A 5 (7-8), 274-284
- *Journal of Materials Science and Engineering,* 2015, vol. A 5 (7-8), 274-284